# FASCICULE DE BREVET EUROPEEN

(11) **EP 2 333 951 B1**
(45) Date de publication et mention de la délivrance du brevet: **11.09.2019**
(21) Numéro de dépôt: 10192424.9
(22) Date de dépôt: 24.11.2010
(51) Int. Cl.: H03F 3/60, H03F 3/72, H03F 3/68, H03F 3/19

(54) **Dispositif d'amplification de puissance de charge utile d'un satellite multifaisceaux de diffusion de données**
Leistungsverstärker für Nutzkanäle für einen Mehrstrahl Nachrichtensatellit
Payload power amplifier for a multi-beam data-broadcasting satellite

(30) Priorité: 02.12.2009 FR 0905817
(43) Date de publication de la demande: 15.06.2011
(73) Titulaire: Centre National d'Etudes Spatiales (C.N.E.S.), 75039 Paris Cedex 01 (FR)
(72) Inventeur: Sombrin, Jacques, 31400 Toulouse (FR); Puech, Jérôme, 31520 Ramonville (FR)
(74) Mandataire: Delorme, Nicolas

(56) Documents cités:
- EP-A2- 0 513 856
- WO-A1-2004/057758
- WO-A1-2008/117400
- US-A- 4 965 587
- US-A- 5 115 248
- US-B1- 6 911 938
- TANAKA M ET AL: "Experimental fixed and mobile multibeam satellite communications system", 19890611; 19890611 - 19890614, 11 juin 1989 (1989-06-11), pages 1587-1594, XP010081320,

## Description

L'invention concerne un dispositif d'amplification de puissance de charge utile d'un satellite artificiel en orbite par rapport à une planète -notamment la Terre- multifaisceaux de diffusion de données, comprenant :
- une pluralité d'antennes de diffusion adaptées chacune pour pouvoir diffuser un signal de données à diffuser,
- une pluralité de circuits d'amplification de puissance comportant chacun une entrée recevant un signal de données à diffuser, et
- des moyens de liaison entre les circuits d'amplification de puissance et les antennes, ces moyens de liaison étant adaptés pour permettre la diffusion, par les antennes, des signaux amplifiés délivrés par les circuits d'amplification.

Une telle charge utile de satellite peut servir par exemple pour diffuser du contenu multimédia (audio et/ou vidéo, programmes de télévision,...) à partir d'un satellite géostationnaire et vers des terminaux mobiles situés au sol. Par exemple, la pluralité d'antennes de diffusion peut correspondre à une pluralité de zones linguistiques à couvrir.

La charge utile d'un tel satellite multifaisceaux de diffusion doit présenter une puissance de diffusion relativement importante pour chaque antenne. En particulier, dans le cas d'un satellite géostationnaire, la puissance de diffusion de la liaison descendante est d'autant plus importante que le satellite est éloigné du sol, et que les récepteurs au sol sont des terminaux mobiles. Typiquement, pour un satellite géostationnaire de diffusion multimédia, la puissance isotrope rayonnée équivalente (PIRE) requise est de l'ordre de 60 à 72 dBW dans 500MHz par antenne de diffusion. De même, dans le cas d'un satellite multifaisceaux en orbite moyenne ou basse, il peut être aussi utile d'adapter au besoin les performances des circuits d'amplification de puissance qui sont des composants dont l'encombrement, la masse et la consommation sont relativement importants dans la conception générale du satellite.

Afin d'optimiser l'usage de la puissance disponible à bord du satellite, il est considéré comme nécessaire de pouvoir disposer d'une flexibilité d'allocation de la puissance embarquée en fonction du ou des signaux de données à diffuser et des antennes disponibles.

Ainsi, il peut être nécessaire de diffuser un seul signal de données avec le maximum de puissance disponible sur une antenne couvrant une zone étendue ou bien de diffuser un ou plusieurs signaux avec une puissance adaptée sur différentes antennes couvrant des régions distinctes, ou encore de pouvoir basculer aisément un même signal entre deux antennes, par exemple pour des besoins de maintenance, etc.

Pour obtenir la flexibilité en puissance mentionnée ci-dessus, il a été envisagé d'intégrer des commutateurs de façon à orienter le signal amplifié vers l'une ou l'autre des antennes de diffusion (cf. par exemple US 6438354). Néanmoins, ces commutateurs doivent être capables d'effectuer une commutation sur un signal radiofréquence à haute puissance. En effet, chaque commutateur est traversé par un signal dont la puissance correspond à toute la puissance de diffusion d'une antenne. De tels composants sont très coûteux, présentent une durée de vie limitée (la durée de vie d'un composant électronique dépendant de sa puissance de fonctionnement), et, du fait qu'ils sont rajoutés spécifiquement dans le circuit de la charge utile (et ne sont donc pas des composants électroniques intégrés et fabriqués en série simultanément à l'ensemble du circuit électronique), affectent la fiabilité générale de la charge utile. En outre, ils peuvent induire des phénomènes parasites (arcs, claquages ou phénomènes inductifs à la commutation, effets d'avalanche électronique en surface (« multipactor »), effets Corona, oscillations transitoires...) d'autant plus significatifs que la puissance transmise est importante. De plus, leur commande nécessite l'utilisation d'un filtrage pour éviter la propagation des oscillations transitoires d'intensité à la commutation. La présence d'un tel filtrage a elle-même pour conséquence d'induire une durée importante de commutation et une consommation d'énergie. En outre, l'utilisation de commutateurs fonctionnant à haute puissance implique, en elle-même, des performances dynamiques réduites en ce sens que la commutation nécessite un délai plus important que dans le cadre d'une commutation à faible puissance, du fait de l'arrêt de la transmission pendant la commutation. Le document US6911938 décrit un autre dispositif d'amplification de puissance de charge utile d'un satellite multifaisceaux de diffusion de données. Dans ce contexte, l'invention vise à fournir un dispositif d'amplification de puissance de charge utile de satellite multifaisceaux de diffusion de données selon la revendication 1, dans lequel la puissance diffusée peut être modifiée en temps réel en fonction des besoins, notamment en envoyant des télécommandes au satellite

L'invention vise en particulier à proposer un tel dispositif d'amplification de puissance qui procure une grande flexibilité d'allocation de la puissance embarquée avec une variation des niveaux de puissance relativement fine, en particulier inférieure à la puissance nominale du dispositif d'amplification embarqué.

L'invention vise en outre à permettre une commutation de signaux de forte puissance entre antennes sans nécessiter le recours à des commutateurs spéciaux.

L'invention vise également plus particulièrement à proposer un tel dispositif d'amplification de puissance qui permette de diffuser un même signal de données sur plusieurs antennes de diffusion distinctes, la puissance de diffusion de ce signal étant répartie entre ces antennes.

L'invention vise également à proposer un tel dispositif d'amplification de puissance qui soit par ailleurs compatible avec son intégration à bord d'un satellite, notamment un satellite géostationnaire.

L'invention vise également à proposer un tel dispositif d'amplification de puissance dont la conception et la fabrication soit par ailleurs simple et n'impose pas de nouvelles étapes de conception spécifiques en ce qui concerne le dispositif d'amplification de puissance lui-même. Plus particulièrement, l'invention vise à proposer un tel dispositif d'amplification de puissance qui puisse être composé de circuits standards fabriqués en série et dont les performances et la fiabilité sont maîtrisées.

Pour ce faire, l'invention concerne un dispositif d'amplification de puissance de charge utile d'un satellite multifaisceaux de diffusion de données, comprenant :
- une pluralité d'antennes de diffusion adaptées chacune pour pouvoir diffuser un signal de données à diffuser,
- une pluralité de circuits d'amplification de puissance comportant chacun une entrée recevant un signal de données à diffuser,
- des moyens de liaison entre les circuits d'amplification de puissance et les antennes, ces moyens de liaison étant adaptées pour permettre la diffusion, par les antennes, des signaux amplifiés délivrés par les circuits d'amplification,
caractérisé en ce que le dispositif comprend :
- pour chaque circuit d'amplification de puissance, un commutateur comportant une borne d'entrée reliée à la sortie du circuit d'amplification de puissance, et au moins deux bornes de sortie,
- des réseaux d'addition reliant au moins une des bornes de sortie de chaque commutateur à une antenne de diffusion, chaque borne de sortie étant reliée à au plus un réseau d'addition et chaque antenne de diffusion étant reliée à un et un seul réseau d'addition, au moins un réseau d'addition comportant au moins un noeud reliant deux branches d'entrée à une branche de sortie, et
- des moyens de commande des commutateurs adaptés pour manoeuvrer ceux-ci de telle sorte que les deux branches d'entrée de chaque noeud d'un réseau d'addition sont alimentées simultanément par un signal de données identique et de même puissance.

Ainsi, dans le dispositif selon l'invention, la commutation des signaux de données amplifiés s'effectue immédiatement après les circuits d'amplification de puissance, à un niveau de puissance du signal qui ne nécessite pas de commutateur spécial. En fonction de la topologie du réseau d'addition auquel les commutateurs relient chaque circuit d'amplification, les puissances élémentaires du signal de données amplifié par chaque circuit d'amplification s'additionnent au niveau de chaque noeud du réseau. Cette addition des puissances est rendue possible par le fait que le signal de données arrivant à chaque noeud est identique et de même puissance sur chacune des branches d'entrées. Les phénomènes d'atténuation et/ou de réflexion parasite du signal de données en présence d'un noeud déséquilibré ne se produisent pas. La puissance délivrée à l'antenne dépend du nombre de rangs de noeuds du réseau d'addition.

Avantageusement et selon l'invention, les circuits d'amplification de puissance sont adaptés pour fournir une puissance compatible avec des commutateurs coaxiaux. Il est ainsi possible de réaliser des modules comprenant un circuit d'amplification de puissance et un commutateur qui sont économiques et faciles à intégrer dans un satellite, notamment lorsqu'on utilise des circuits d'amplification à base d'amplificateurs de puissance à l'état solide.

Avantageusement et selon l'invention, les circuits d'amplification de puissance reliés à un même réseau d'addition reçoivent en entrée un même signal de données. En association avec un système de distribution du signal de données sur les entrées des circuits d'amplification, cette caractéristique permet la diffusion d'un même signal ou de signaux distincts sur les différentes antennes.

Avantageusement et selon l'invention, les branches d'entrée de chaque noeud d'un réseau d'addition sont reliées à un même nombre de circuits d'amplification. De cette manière, la puissance arrivant à chaque noeud d'un réseau d'addition est identique sur chacune des branches d'entrées et se traduit par une puissance double dans la branche de sortie du noeud.

Avantageusement et selon l'invention, le dispositif de l'invention comporte au moins un réseau d'addition adapté pour relier tous les circuits d'amplification à une même antenne. Il est ainsi possible de diriger toute la puissance embarquée sur une antenne unique en commandant les commutateurs de manière à connecter tous les circuits d'amplification de puissance sur ce réseau.

Avantageusement et selon l'invention, les réseaux d'additions sont agencés de telle sorte que dans une première position des commutateurs, tous les circuits d'amplification sont reliés à une même antenne et dans une seconde position des commutateurs, les circuits d'amplification sont reliés par groupes d'effectif décroissant vers des antennes de puissance correspondante. Cette disposition permet ainsi de diffuser un même signal de données soit sur une seule antenne avec un maximum de puissance, soit au moyen de plusieurs antennes, avec des puissances adaptées en fonction des régions à couvrir.

Avantageusement et selon l'invention, le dispositif comporte au moins deux réseaux identiques reliés chacun à une antenne de diffusion et les commutateurs des circuits d'amplification reliés à ces réseaux sont adaptés pour permettre un basculement du signal de données à diffuser d'une antenne vers l'autre. Grâce à cette caractéristique, le basculement d'un signal de forte puissance d'une première antenne de diffusion vers une deuxième antenne peut s'effectuer sans utiliser un commutateur de forte puissance. Ainsi des opérations de maintenance comme la réorientation d'une antenne du parc d'antennes du satellite sont facilitées.

Avantageusement et selon l'invention, les branches d'entrée de chaque noeud sont de longueur identique. Ceci permet d'éviter que les temps de propagation du signal de données n'introduisent des déphasages au niveau des noeuds et détériorent la duplication de la puissance d'émission au niveau de ceux-ci.

Avantageusement et selon l'invention, les moyens de commande des commutateurs sont adaptés pour être commandés simultanément par une commande de commutation télétransmise au satellite. De cette manière la reconfiguration de tout ou partie de la charge utile du satellite peut être télécommandée depuis une station au sol.

L'invention s'étend également à un satellite multifaisceaux de diffusion de données caractérisé en ce qu'il comprend au moins une charge utile comprenant au moins un dispositif d'amplification de puissance selon l'invention, alimentant au moins une partie de ses antennes de diffusion.

L'invention concerne également un dispositif d'amplification de puissance caractérisé en combinaison par tout ou partie des caractéristiques mentionnées ci-dessus ou ci-après.

D'autres buts, caractéristiques et avantages de l'invention apparaîtront au vu de la description qui va suivre et des dessins annexés dans lesquels :
- la figure 1 est une vue schématique d'un satellite selon l'invention,
- la figure 2 est un schéma général d'une charge utile de satellite selon un mode de réalisation de l'invention,
- la figure 3 représente une variante d'un dispositif d'amplification de puissance selon l'invention adapté à la commutation d'antennes,
- la figure 4 représente une variante de réalisation d'un dispositif d'amplification de puissance selon l'invention comportant des possibilités de commutation étendues.

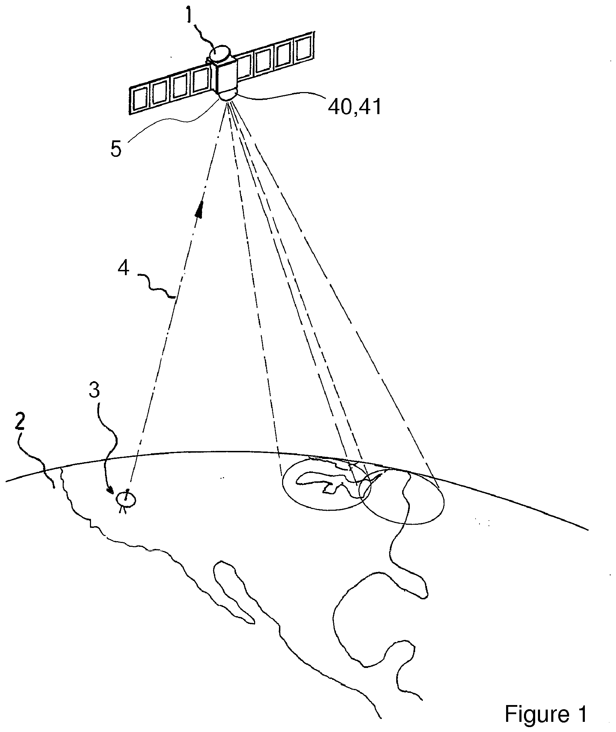

La figure 1 représente un exemple de satellite 1 géostationnaire selon l'invention multifaisceaux, c'est-à-dire comprenant une pluralité d'antennes de diffusion 40, 41 (à savoir deux antennes de diffusion uniquement dans l'exemple représenté sur cette figure).

Les signaux de données à diffuser sont émis depuis au moins une station sol 3 par au moins une liaison montante 4, le satellite 1 présentant au moins une antenne (ou faisceau) de réception 5.

La figure 1 ne représente qu'un exemple, et il est entendu que l'invention s'applique à toute autre configuration, par exemple à chaque satellite d'une constellation de satellites, au cas de satellites multifaisceaux comprenant un nombre d'antennes de diffusion supérieur à 2, à des satellites non géostationnaires...

La charge utile d'un satellite 1 de diffusion multimédia compatible avec les normes 3G comprend plusieurs antennes de diffusion couvrant chacune une région, par exemple un pays, et reçoit du sol 2 des données numériques à diffuser sur différentes régions. Ces données sont converties en une pluralité de canaux à diffuser, chaque canal étant amplifié et délivré à une antenne de diffusion.

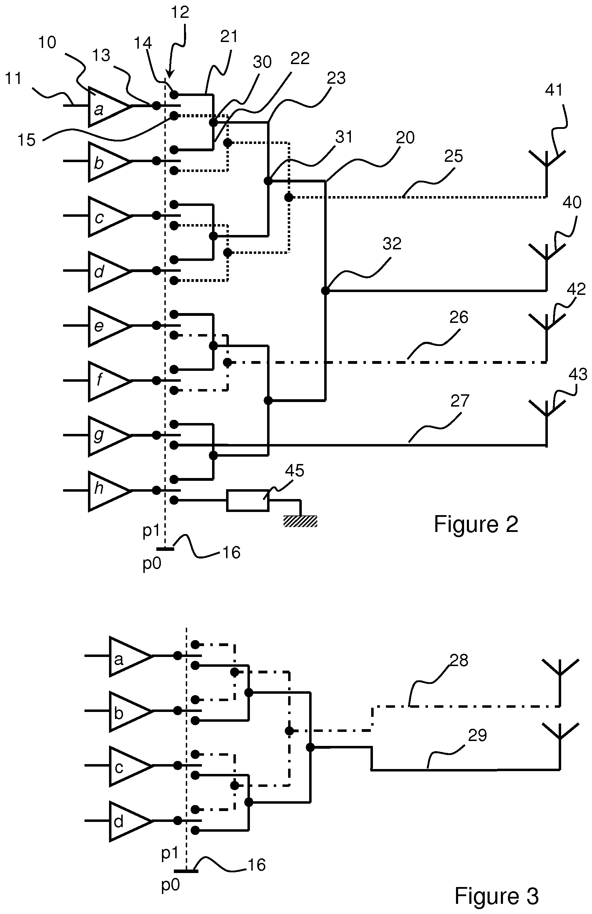

La figure 2 représente un exemple de configuration d'un dispositif d'amplification de puissance formant partie de la charge utile d'un tel satellite et permettant la diffusion d'un signal de données vers une ou plusieurs zones de couverture au sol.

Le dispositif d'amplification de puissance selon l'invention comporte une pluralité de circuits d'amplification 10 de puissance, notés de *a* à *h* par exemple. De préférence, un dispositif d'amplification comporte 2ⁿ circuits d'amplification, n étant un nombre entier non nul. Chaque circuit d'amplification 10 comporte une entrée 11 de signal adaptée pour recevoir un signal de données à amplifier en provenance d'étages antérieurs de réception et de conditionnement de signal non représentés. La sortie de chaque circuit d'amplification 10 est reliée à la borne d'entrée 13 d'un commutateur 12 qui comporte au moins deux bornes de sortie 14 et 15.

Les circuits d'amplification 10 peuvent être réalisés, en fonction des bandes de fréquences utilisées, au moyen de tubes à ondes progressives fournissant une puissance de sortie RF comprise entre 50 et 500W ou encore au moyen de circuits d'amplification à état solide (SSPA) fournissant une puissance de sortie comprise entre 10 et 90 W. Chaque circuit d'amplification 10 peut être constitué d'un seul tube ou circuit SSPA ou bien de plusieurs tubes ou circuits en parallèle.

Avantageusement, la puissance de sortie des circuits d'amplification 10 est choisie de manière à être compatible avec des commutateurs 12 coaxiaux, par exemple des commutateurs coaxiaux de qualité spatiale du type SPDT, DPDT, DP3T, etc. commercialisés par la société RADIALL. Chaque couple circuit d'amplification 10 et commutateur 12 peut ainsi être combiné sous la forme d'un module standard permettant une fabrication et des tests en série plus économiques et une intégration aisée dans un satellite.

Pour des raisons de clarté du dessin, les références relatives au circuit d'amplification 10 et au commutateur 12 n'ont été portées que sur le premier circuit d'amplification noté a et sur le commutateur correspondant. Dans le texte qui suit, lorsqu'il sera nécessaire de distinguer les éléments des différents circuits d'amplification et commutateurs, on utilisera la référence générale de l'élément assortie de la lettre correspondant au circuit d'amplification correspondant. Ainsi par exemple, on note 14g la borne de sortie 14 du commutateur 12g associé au circuit d'amplification 10g.

Dans l'exemple représenté à la figure 2, les commutateurs 12 sont commandés par des moyens de commande 16 permettant de commander la connexion de la borne d'entrée 13 à la borne de sortie 14 dans une première position repérée par p1 et à la borne de sortie 15 dans une seconde position repérée p0. Les moyens de commande 16 sont adaptés pour commander simultanément la commutation des commutateurs 12.

Les bornes de sortie 14 et 15 des commutateurs 12a à 12h sont reliées à des réseaux d'addition 20, 25, 26 et 27 reliant ces bornes de sortie des commutateurs à des antennes 40, 41, 42, 43 de diffusion. Chaque borne de sortie est reliée à au plus un réseau d'addition. Ainsi, par exemple, la borne de sortie 14a est reliée uniquement au réseau d'addition 20.

En outre, chaque antenne de diffusion est reliée à un et un seul réseau d'addition. Par exemple, l'antenne 40 est uniquement reliée au réseau d'addition 20, de même que les antennes 41, 42 et 43 sont reliées respectivement uniquement aux réseaux d'addition 25, 26 et 27. Ainsi chaque réseau d'addition relie une borne de sortie d'un ou plusieurs commutateurs à une et une seule antenne de diffusion.

Les réseaux d'addition sont constitués de lignes conductrices adaptées à la fréquence et à la puissance du signal transporté et réalisées de manière connue en elle-même par l'homme du métier, au moyen de câbles coaxiaux ou de guides d'ondes ou encore d'une combinaison des deux.

A l'exception de la ligne qui relie la borne 15h à une charge dissipative 45 et du réseau d'addition 27 qui relie directement la borne de sortie 15g du commutateur 12g à l'antenne 43, tous les autres réseaux d'addition comportent au moins un noeud reliant deux branches du réseau d'addition, dites branches d'entrée, situées entre les bornes de sortie des commutateurs et le noeud considéré, à une branche de sortie située entre le noeud considéré et l'antenne de diffusion associée au réseau d'addition.

Ainsi, le réseau d'addition 20 comporte un noeud 30 auquel les branches d'entrée 21 et 22 sont reliées en provenance respectivement des bornes de sortie 14a du commutateur 12a et 14b du commutateur 12b. A partir du noeud 30, une branche de sortie 23 s'étend en direction de l'antenne de diffusion 40. A noter que cette branche de sortie 23 est également une branche d'entrée pour le noeud 31 de rang 2 dans le réseau d'addition 20. Le réseau d'addition 20 comprend ainsi sept noeuds appartenant à trois rangs distincts, quatre noeuds de rang 1 tel le noeud 30, deux noeuds de rang 2 tel le noeud 31 auxquels arrivent des branches d'entrée en provenance des noeuds de rang 1 et un noeud 32 de rang 3 auquel arrivent des branches d'entrée en provenance des noeuds de rang 2 et d'où part une branche de sortie reliée à l'antenne de diffusion 40. On note ainsi que le réseau d'addition 20 relie toutes les bornes de sortie 14 des commutateurs 12 à l'antenne de diffusion 40.

De manière similaire, le réseau d'addition 25 comporte deux noeuds de rang 1 et un seul noeud de rang 2 relié à l'antenne de diffusion 41 et le réseau d'addition 26 ne comporte qu'un seul noeud de rang 1 relié à l'antenne de diffusion 42. Ainsi, les branches d'entrée de chaque noeud d'un réseau d'addition sont reliées à un nombre identique de circuits d'amplification 10, au travers d'un ou plusieurs noeuds intermédiaires. Dès lors, si les circuits d'amplification 10 sont de même puissance de sortie, le signal de données qui alimente les branches d'entrée d'un noeud est identique et de même puissance P sur chaque branche, et le signal résultant sur la branche de sortie du noeud est un signal de données identique et de puissance double 2P.

Ainsi, lorsque les moyens de commande 16 des commutateurs sont en position p1, toutes les bornes d'entrée 13 des commutateurs 12 sont reliées aux bornes de sortie 14 qui sont elles-mêmes reliées au réseau d'addition 20. Si tous les circuits d'amplification 10a à 10h sont alimentés par un même signal de données sur leur entrée 11, par exemple au moyen d'un multiplexeur (non représenté), les signaux de sortie des circuits d'amplification sont identiques et de puissance P correspondant à la puissance délivrée par un circuit d'amplification. En sortie de chaque noeud de rang 1, le signal de données est donc de puissance 2P. En sortie des noeuds de rang 2, le signal de données est alors de puissance égale à 4P et en sortie du noeud 32, de rang 3, un signal de données de puissance égale à 8P est prêt pour être diffusé par l'antenne de diffusion 40.

Avantageusement, les branches d'entrée de chaque noeud sont de même longueur de manière à éviter des déphasages du signal arrivant au noeud du fait de longueurs de trajet différentes. En effet, ces éventuels déphasages pourraient être préjudiciables à la duplication de la puissance au niveau de ce noeud et pourraient entrainer divers effets indésirables comme des atténuations et/ou un échauffement du noeud.

Lorsque les moyens de commande 16 des commutateurs sont en position p0, toutes les bornes d'entrée 13 des commutateurs 12 sont reliées aux bornes de sortie 15. Dans ce cas, selon l'exemple représenté à la figure 2, les circuits d'amplification 10a à 10d sont reliés au réseau 25 qui permet de délivrer un signal de données d'une puissance de 4P sur l'antenne de diffusion 41, les circuits d'amplification 10e et 10f sont reliés au réseau 26 qui permet de délivrer un signal de données d'une puissance de 2P sur l'antenne de diffusion 42 et le circuit d'amplification 10g fournit un signal de puissance P sur l'antenne de diffusion 43.

De manière plus générale, un dispositif d'amplification selon l'invention, comportant 2ⁿ circuits d'amplification peut être connecté à un réseau d'addition comportant n rangs de noeuds pour délivrer sur une antenne de diffusion une puissance égale à 2ⁿ fois la puissance élémentaire d'un circuit d'amplification, sans pour autant faire usage de commutateurs spéciaux. Selon une autre position de commande des commutateurs, le signal de données peut être diffusé par n antennes de diffusion différentes avec des puissances étagées entre 2⁰ P et 2ⁿ⁻¹ P.

Avantageusement, en associant le dispositif d'amplification selon l'invention avec un moyen d'alimentation sélectif des entrées 11 des circuits d'amplification 10, tel qu'un multiplexeur par exemple, on peut alors reconfigurer la charge utile d'un satellite pour pouvoir émettre un signal avec une puissance correspondant à toute la puissance embarquée ou ce même signal sur n antennes correspondant à n zones à couvrir avec des puissances étagées en fonction des zones ou encore n signaux différents avec des puissances étagées de façon analogue. En effet, il suffit alors de fournir un signal distinct à chaque groupe de circuits d'amplification reliés à un même réseau d'addition.

L'exemple de la figure 3 du dessin annexé présente une variante du dispositif d'amplification selon l'invention permettant de commuter toute la puissance fournie par les circuits d'amplification (ici, quatre circuits a, b, c et d) sur deux antennes de diffusion distinctes. Pour ce faire, les moyens de commande 16 sont adaptés pour commander simultanément les commutateurs associés à chaque circuit d'amplification de manière à relier la sortie de ceux-ci à l'un ou l'autre de deux réseaux d'addition 28 et 29 identiques connectés chacun à une antenne de diffusion. De cette manière, le basculement d'un signal de données de forte puissance (dépendant du nombre de circuits d'amplification du dispositif) d'une antenne vers une autre peut être réalisé sans nécessiter de commutateur de puissance.

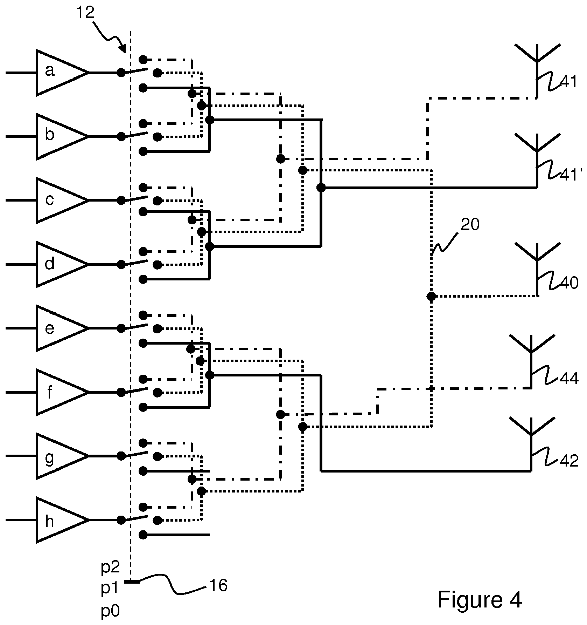

Bien entendu, les commutateurs 12 ne sont pas limités à des commutateurs présentant une entrée et deux sorties. Pour augmenter la versatilité et les possibilités de reconfiguration de la charge utile du satellite, on peut prévoir, comme montré sur la figure 4, que les commutateurs 12 comportent plus de deux sorties (par exemple trois) et que les moyens de commande 16 associés comportent également plus de deux positions. Ainsi, dans l'exemple de la figure 4, lorsque les moyens de commande sont en position intermédiaire p1, toute la puissance disponible des circuits d'amplification *a* à *h* est routée vers l'antenne de diffusion 40 via le réseau d'addition 20, comme dans le cas de la figure 2. En outre, en pilotant les moyens de commutation de la position p0 à la position p2, on bascule la puissance de sortie des circuits d'amplification *a* à *d* entre les antennes de diffusion 41 et 41', on met en service une antenne de diffusion 44 alimentée par les circuits d'amplification *e* à *h* à la place de l'antenne 42 de puissance inférieure qui n'était alimentée que par les circuits *e* et *f,* etc.

Ainsi, les possibilités de reconfiguration d'un satellite ne sont limitées que par le nombre de positions possibles des commutateurs et la topologie des réseaux d'addition qui leur sont associés, et bien entendu par les antennes de diffusion disponibles.

Avantageusement, les possibilités de reconfiguration peuvent être télécommandées par un signal de commande télétransmis à partir de la station sol 3 via la liaison montante 4. Pour cela, les moyens de commande 16 sont adaptés pour être pilotés par un signal de commande de commutation télétransmis. De préférence, les commutateurs 12 et les réseaux d'addition sont agencés pour que, dans un même dispositif d'amplification, un seul signal de commande de commutation entraine la commutation simultanée de tous les commutateurs dans la position désirée. Cependant, il est également possible de prévoir que chaque commutateur puisse être adressé individuellement par le signal de commande télétransmis.

Bien entendu, cette description est donnée à titre d'exemple illustratif uniquement et l'homme du métier pourra y apporter de nombreuses modifications sans sortir de la portée de l'invention telle que définie par les revendications annexées, comme par exemple constituer la charge utile du satellite avec plusieurs dispositifs d'amplification selon l'invention, adaptés pour remplir des missions distinctes et/ou complémentaires.

## Revendications

1. Dispositif d'amplification de puissance de charge utile d'un satellite multifaisceaux de diffusion de données, comprenant :
• une pluralité d'antennes de diffusion (40, 41, 42, 43, 44) adaptées chacune pour pouvoir diffuser un signal de données à diffuser,
• une pluralité de circuits d'amplification (10) de puissance comportant chacun une entrée (11) adaptée pour recevoir un signal de données à diffuser,
• des moyens de liaison entre les circuits d'amplification (10) de puissance et les antennes, ces moyens de liaison étant adaptées pour permettre la diffusion, par les antennes, des signaux amplifiés délivrés par les circuits d'amplification,
• pour chaque circuit d'amplification (10) de puissance, un commutateur (12) comportant une borne d'entrée (13) reliée à la sortie du circuit d'amplification de puissance, et au moins deux bornes de sortie (14, 15),
• des réseaux d'addition (20, 25, 26, 27,28, 29) reliant au moins une des bornes de sortie (14, 15) de chaque commutateur (12) à une antenne de diffusion (40, 41, 42, 43, 44), chaque borne de sortie étant reliée à au plus un réseau d'addition et chaque antenne de diffusion étant reliée à un et un seul réseau d'addition,
• des moyens de commande des commutateurs, où
• chaque réseau d'addition comporte au moins un noeud (30, 31, 32) reliant deux branches d'entrée (21, 22) à une branche de sortie (23), **caractérisé en ce que**
• les moyens de commande (16) des commutateurs (12) sont adaptés pour manoeuvrer ceux-ci de telle sorte que les deux branches d'entrée de chaque noeud d'un réseau d'addition sont alimentées simultanément par un signal de données identique et de même puissance,
le dispositif comportant 2" circuits d'amplification connectés à un réseau d'addition comportant n rangs de noeuds pour délivrer sur une antenne de diffusion une puissance égale à 2" fois la puissance élémentaire d'un circuit d'amplification, n étant supérieur ou égal à deux.

2. Dispositif selon la revendication 1, où les circuits d'amplification (10) de puissance sont adaptés pour fournir une puissance compatible avec des commutateurs (12) coaxiaux.

3. Dispositif selon l'une des revendications 1 ou 2, où les circuits d'amplification (10) de puissance reliés à un même réseau d'addition reçoivent en entrée un même signal de données.

4. Dispositif selon l'une des revendications 1 à 3, où les branches d'entrée (21, 22) de chaque noeud (30, 31, 32) d'un réseau d'addition sont reliées à un même nombre de circuits d'amplification (10).

5. Dispositif selon l'une des revendications 1 à 4, comportant au moins un réseau d'addition (20) adapté pour relier tous les circuits d'amplification (10) à une même antenne (40).

6. Dispositif selon la revendication 5, où les réseaux d'additions sont agencées de telle sorte que dans une première position (p1) des commutateurs (12), tous les circuits d'amplification sont reliés à une même antenne et dans une seconde position (p0) des commutateurs, les circuits d'amplification sont reliés par groupes d'effectif décroissant à des antennes de puissance correspondante.

7. Dispositif selon la revendication 5 ou 6, comportant au moins deux réseaux d'addition (28, 29) identiques reliés chacun à une antenne de diffusion et en ce que les commutateurs (12) des circuits d'amplification (10) reliés à ces réseaux sont adaptés pour permettre un basculement du signal de données à diffuser d'une antenne vers l'autre.

8. Dispositif selon l'une des revendications 1 à 7, où les branches d'entrée (21, 22) de chaque noeud (30, 31, 32) sont de longueur identiques.

9. Dispositif selon l'une des revendications 1 à 8, où les moyens de commande (16) des commutateurs (12) sont adaptés pour être commandés simultanément par une commande de commutation télétransmise au satellite.

10. Satellite multifaisceaux de diffusion de données comprenant au moins une charge utile comprenant au moins un dispositif d'amplification de puissance selon l'une des revendications 1 à 9, alimentant au moins une partie de ses antennes de diffusion.

## Patentansprüche

1. Vorrichtung zur Leistungsverstärkung für Nutzkanäle für einen Mehrstrahl-Datenübertragungssatelliten, umfassend:
- eine Vielzahl von Sendeantennen (40, 41, 42, 43, 44), die jeweils geeignet sind, ein zu übertragendes Datensignal zu senden,
- eine Vielzahl von Leistungsverstärkerschaltungen (10), die jeweils einen Eingang (11) aufweisen, der für den Empfang eines zu übertragenden Datensignals geeignet ist,
- Verbindungsmittel zwischen den Leistungsverstärkerschaltungen (10) und den Antennen, wobei diese Verbindungsmittel dazu geeignet sind, das Senden, durch die Antennen, der von den Verstärkerschaltungen bereitgestellten verstärkten Signale zu erlauben,
- für jede Leistungsverstärkerschaltung (10), einen Umschalter (12), aufweisend eine Eingangsklemme (13), die mit dem Ausgang der Leistungsverstärkungsschaltung verbunden ist, und mindestens zwei Ausgangsklemmen (14, 15),
- Zusatznetze (20, 25, 26, 27,28, 29), die mindestens eine der Ausgangsklemmen (14, 15) jedes Umschalters (12) mit einer Sendeantenne (40, 41, 42, 43, 44) verbinden, wobei jede Ausgangsklemme mit höchstens einem Zusatznetz verbunden ist und jede Sendeantenne mit einem und einem einzigen Zusatznetz verbunden ist,
- Steuermittel der Umschalter, wobei
- jedes Zusatznetz mindestens einen Knoten (30, 31, 32) aufweist, der zwei Eingangszweige (21, 22) mit einem Ausgangszweig (23) verbindet, **dadurch gekennzeichnet, dass**
- die Steuermittel (16) der Umschalter (12) dazu geeignet sind, diese derart zu manövrieren, dass die zwei Eingangszweige jedes Knotens eines Zusatznetzes gleichzeitig mit einem identischen Datensignal und derselben Leistung versorgt werden,
wobei die Vorrichtung 2ⁿ Verstärkerschaltungen aufweist, die an ein Zusatznetz angeschlossen sind, aufweisend n Reihen von Knoten, um über eine Sendeantenne eine Leistung von gleich dem 2ⁿ-fachen der elementaren Leistung einer Verstärkerschaltung bereitzustellen, wobei n größer oder gleich zwei ist.

2. Vorrichtung nach Anspruch 1, wobei die Leistungsverstärkerschaltungen (10) dazu geeignet sind, eine Leistung bereitzustellen, die mit koaxialen Umschaltern (12) kompatibel ist.

3. Vorrichtung nach einem der Ansprüche 1 oder 2, wobei die Leistungsverstärkerschaltungen (10), die mit einem selben Zusatznetz verbunden sind, am Eingang ein selbes Datensignal empfangen.

4. Vorrichtung nach einem der Ansprüche 1 bis 3, wobei die Eingangszweige (21, 22) jedes Knotens (30, 31, 32) eines Zusatznetzes mit einer selben Anzahl von Verstärkerschaltungen (10) verbunden sind.

5. Vorrichtung nach einem der Ansprüche 1 bis 4, aufweisend mindestens ein Zusatznetz (20), das dazu geeignet ist, alle Verstärkerschaltungen (10) mit einer selben Antenne (40) zu verbinden.

6. Vorrichtung nach Anspruch 5, wobei die Zusatznetze derart eingerichtet sind, dass in einer ersten Position (p1) der Umschalter (12) alle Verstärkerschaltungen mit einer selben Antenne verbunden sind und in einer zweiten Position (p0) der Umschalter die Verstärkerschaltungen in Gruppen mit abnehmender Stärke mit Antennen entsprechender Leistung verbunden sind.

7. Vorrichtung nach Anspruch 5 oder 6, aufweisend mindestens zwei identische Zusatznetze (28, 29), die jeweils mit einer Sendeantenne verbunden sind und dadurch, dass die Umschalter (12) der Verstärkerschaltungen (10), die mit diesen Netzen verbunden sind, dazu geeignet sind, ein Umschalten des zu übertragenden Datensignals von einer Antenne zur anderen zu erlauben.

8. Vorrichtung nach einem der Ansprüche 1 bis 7, wobei die Eingangszweige (21, 22) jedes Knotens (30, 31, 32) identisch lang sind.

9. Vorrichtung nach einem der Ansprüche 1 bis 8, wobei die Steuermittel (16) der Umschalter (12) dazu geeignet sind, gleichzeitig von einer an den Satelliten fernübertragenen Umschaltsteuerung gesteuert zu werden.

10. Mehrstrahl-Datenübertragungssatellit, umfassend mindestens einen Nutzkanal, umfassend mindestens eine Leistungsverstärkungsvorrichtung nach einem der Ansprüche 1 bis 9, die mindestens einen Teil seiner Sendeantennen versorgt.

## Claims

1. A payload power amplification device of a data broadcasting multibeam satellite, comprising:
• a plurality of broadcast antennas (40, 41, 42, 43, 44) each adapted to be able to broadcast a data signal to be broadcast,
• a plurality of power amplification circuits (10) each including an input (11) adapted to receive a data signal to be broadcast,
• connection means between the power amplification circuits (10) and the antennas, these connection means being adapted to enable the broadcast, by the antennas, of the amplified signals delivered by the amplification circuits,
• for each power amplification circuit (10), a switch (12) including an input terminal (13) connected to the output of the power amplification circuit, and at least two output terminals (14, 15),
• summing networks (20, 25, 26, 27, 28, 29) connecting at least one of the output terminals (14, 15) of each switch (12) to a broadcast antenna (40, 41, 42, 43, 44), each output terminal being connected to at most one summing network and each broadcast antenna being connected to one and only one summing network,
• means for controlling the switches, where
• each summing network includes at least one node (30, 31, 32) connecting two input branches (21, 22) to an output branch (23), **characterized in that**
• the means (16) for controlling the switches (12) are adapted to maneuver said switches such that the two input branches of each node of a summing network are simultaneously supplied by a data signal which is identical and of the same power,
the device including 2ⁿ amplification circuits connected to a summing network including n ranks of nodes to deliver, on a broadcast antenna, a power equal to 2ⁿ times the elementary power of an amplification circuit, n being greater than or equal to two.

2. The device according to claim 1, where the power amplification circuits (10) are adapted to supply a power compatible with coaxial switches (12).

3. The device according to any of claims 1 or 2, where the power amplification circuits (10) connected to the same summing network receive, at the input, the same data signal.

4. The device according to any of claims 1 to 3, where the input branches (21, 22) of each node (30, 31, 32) of a summing network are connected to the same number of amplification circuits (10).

5. The device according to any of claims 1 to 4, including at least one summing network (20) adapted to connect all amplification circuits (10) to the same antenna (40).

6. The device according to claim 5, where the summing networks are arranged such that, in a first position (p1) of the switches (12), all amplification circuits are connected to the same antenna and, in a second position (p0) of the switches, the amplification circuits are connected by groups of decreasing size to antennas of a corresponding power.

7. The device according to claim 5 or 6, including at least two identical summing networks (28, 29), each connected to a broadcast antenna and in that the switches (12) of the amplification circuits (10) connected to these networks are adapted to enable a toggling of the data signal to be to broadcast from one antenna to the other.

8. The device according to any of claims 1 to 7, where the input branches (21, 22) of each node (30, 31, 32) have identical lengths.

9. The device according to any of claims 1 to 8, where the means (16) for controlling the switches (12) are adapted to be simultaneously controlled by a switch command tele-transmitted to the satellite.

10. A data broadcasting multibeam satellite comprising at least one payload comprising at least one power amplification device according to any of claims 1 to 9, supplying at least one portion of the diffusion antennas thereof.
